# EUROPEAN PATENT APPLICATION

(11) **EP 0 571 235 A1**
(43) Date of publication of application: **24.11.1993**
(21) Application number: 93303992.7
(22) Date of filing: 21.05.1993
(51) Int. Cl.: B23K 11/00, H01M 2/22

(54) **Process for spot-welding a flexible welding board to a battery cell**

(30) Priority: 22.05.1992 US 886866
(71) Applicant: ALEXANDER MANUFACTURING COMPANY, Mason City, Iowa 50401 (US)
(72) Inventor: Alexandres, Richard B., Clear Lake, IA 50428 (US); Villeponteaux, George W., Mason City, IA 50401 (US)
(74) Representative: Parr, Ronald Edward R.E. Parr & Co.

(57) **Abstract**

Process for spot-welding a flexible bare backed welding board to at least one and preferably a plurality battery cells to form a battery pack, such as a NiCad battery pack. The flexible bare backed welding board is a nickel or other metal alloy material, laminated to a polyester film by a co-extruded or otherwise applied adhesive. The spot-welding is accomplished by one spot-welder, and preferably two spot-welders, which spot-weld in alternating time intervals so as to assure electrical and electromechanical contact with each end of the battery cells by the nickel alloy material. The spot-welding is by DC current and voltage or alternatively can be AC welded. The electrodes are small enough to form a configuration between the flexible circuit and the end of the battery cell. Three spot-welding electrodes would assume a triangular configuration. Four spot-welding electrodes would form a rectangular configuration.

## Description

This invention relates to a process of welding, for example by spot-welding, a bare backed flexible welding board to a battery cell and to apparatus for use in the process. In particular it relates to a process and apparatus for spot-welding a laminate of a bare backed flexible welding board and a metal alloy or other metal strip or other sheet to one or more battery cells to produce a battery pack.

Battery packs, such as nickel-cadmium (NiCad) battery packs, in the past have been manufactured by a process comprising the welding of stainless steel or nickel straps to battery cells. However, this process is expensive in time and motion in that it requires the individual welding of each battery cell for connection to the straps.

The present invention overcomes this disadvantage by using a bare backed flexible welding board which can be spot-welded directly to the battery cells, and particularly lends itself to robotic manufacturing processes.

Accordingly, in a first aspect the present invention provides a process for spot-welding a flexible welding board to at least one battery cell, characterised in that it comprises:
(a) using as the flexible welding board a flexible bare backed welding board;
(b) forming an electrical circuit pattern on the welding board;
(c) orienting a battery cell with respect to said electrical circuit pattern; and
(d) spot-welding said electrical circuit pattern to said battery cell.

In a second aspect the present invention provides apparatus for producing a battery pack, characterised in that the apparatus comprises:
(a) means for supplying flexible bare backed welding boards;
(b) means for forming said flexible bare backed welding boards into a U-shaped configuration;
(c) means for feeding at least one battery cell between the legs of one of the U-shaped flexible bare backed welding boards; and
(d) spot welding means for bonding said flexible bare backed welding board to the terminals of the said at least one battery cell.

Other, optional electrical components or electromechanical components can be spot-welded to the flexible welding board.

The invention is described below with particular reference to an automated process for spot-welding a flexible bare backed welding board to battery cells, including at least two spot-welders for alternately welding, at two or more different locations, each end of a battery cell to a flexible bare backed welding board. By means of this particular process electrical and electromechanical weld integrity can be attained. In one example, the battery cell and bare backed welding board are spot-welded by a triangular configuration of a negative electrode and two positive electrodes , each of the positive electrodes being connected to independent sources of welding power and energized independently of each other to provide separate welds. This provides that there are two separate spot-welds and also provides for the integrity of each of the spot-welds.

Preferred embodiments of the present invention can have one or more of the following features:
(a) the process is particularly and ideally suited for automated manufacturing of NiCad and other battery packs
(b) the process can be completely automated to expedite manufacture.

The bare backed flexible welding board used in the proces and/or apparatus of the present invention and the battery packs obtained can, for example, be as described in our European Patent Application of even date which claims priority from United States Application 07/886 869 filed 22 May 1992.

There are now described, by way of example and with reference to the accompanying drawings, a process and apparatus for making a battery pack as preferred embodiments of the present invention.

In the drawings:
FIG. 1 is a diagrammatic plan view of apparatus for use in a process of spot-welding a flexible welding board to a battery cell;
FIG. 2 is a diagrammatic view of one of the spot welders shown in Figure 1; and
FIG. 3 is a plan view of a flexible welding board used in the process.

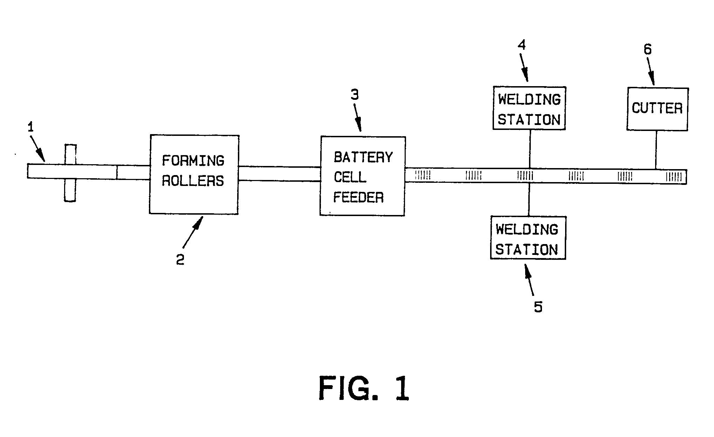

FIG. 1 illustrates an apparatus for and a process of spot-welding a flexible bare backed welding board to battery cells to form a battery pack. The process is intended to weld a plurality of battery cells to form a battery pack, and any suitable number of cells and types of cells can be utilized in the process. Prepunched holes in the flexible bare backed welding board geometrically conform to the battery cells prior to welding the electrical contact portion of each cell to the flexible welding board. At least two spot welds are utilized, although any other type of industrial welding could be utilized, for example laser welding or electron beam welding. The process of welding the flexible bare backed board to battery cells is intended for welding either a single flexible bare backed welding board about at least one or a plurality of cells, or for use in robotic or other continuous welding applications.

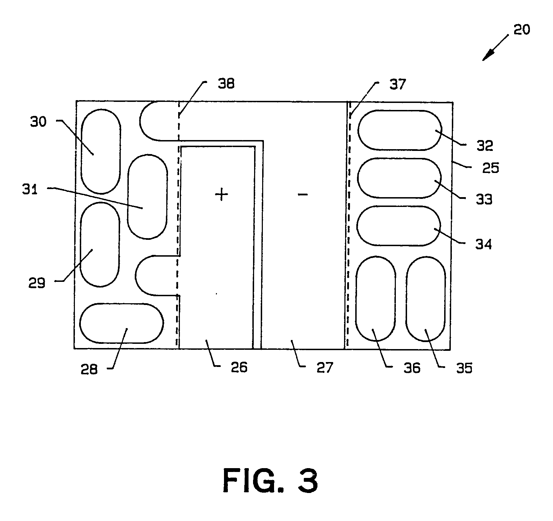

With reference to Figure 1, in a robotic form of the process a continuous coil of flexible welding boards (1), (formed, as will be described in later detail, with reference to FIG. 3) is pulled through driven forming rollers (2). The forming rollers (2) convert the flat flexible welding board into a U-shaped configuration with the legs of the U facing upwards as viewed from above in FIG. 1. The formed flexible welding board (1) then passes underneath a battery cell feeder (3) which deposits the desired number of cells (19) arranged and suitably bonded together, such as by hot glue or adhesive, between the legs of the formed flexible welding board (1) with the terminals facing up and down as viewed in FIG. 1. The formed flexible welding board and battery cells (19) move to welding stations (4 and 5) where metal or metal alloy (for example stainless steel) straps and pads, as shown in FIG. 3, are spot-welded to each of the terminals of the battery cells, forming a battery pack. The battery pack passes to a cutter (6) where successive individual battery packs are separated from the now continuous formed strip.

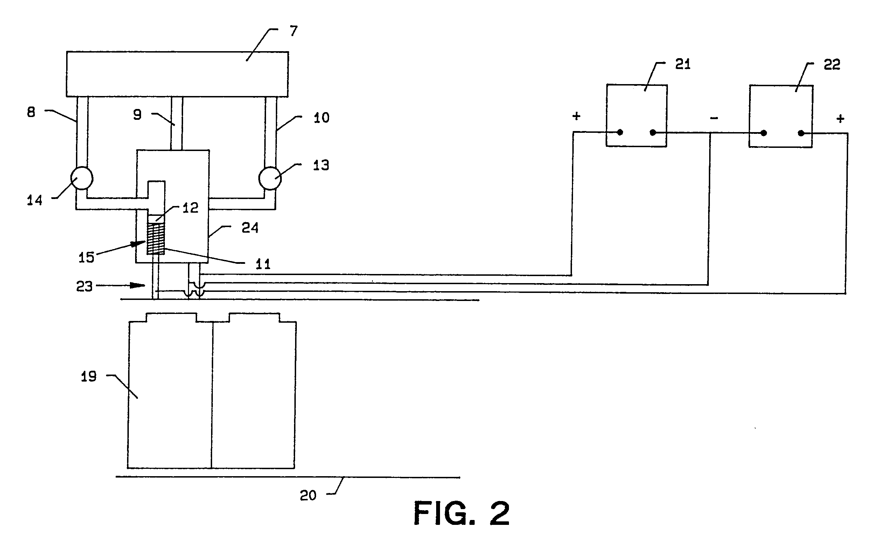

FIG. 2 illustrates in greater detail one of the welding stations (4 and 5) shown in FIG. 1. The welding station consists of a fluid pressure source (7) which supplies pressure over lines (8, 9 and 10) through electric valves (13 and 14) and a third valve in supply line (9) (not illustrated). Supply lines (8, 9 and 10) connect to three cylinders (11), only one being illustrated, formed in a housing (24). The cylinders (11) are electrically insulated each from the other. Within each cylinder is a piston (12) to which is connected a spot welding electrode (23). A spring (15), below the piston (12), functions to return electrode (23) upon release of pressure by valves in the supply lines (8,9 and 10). Separate isolated power sources (21 and 22) have their negative terminals commonly connected, and then connect to each one of the welding electrodes. High frequency welding or other welding methods can also be incorporated. The positive terminals are connected to the remaining two spot-welding electrodes. The electrodes are arranged in a triangular configuration, although other geometrical configurations can be utilized as contemplated. The electrodes can be energized in pairs or simultaneously as desired. The spot welder system, as illustrated, will provide three distinct spot welds, ensuring both mechanical and electrical integrity.

In FIG. 3 a flexible polyester sheet (25) is co-extruded with a polymer adhesive or like material on one surface thereof or can be otherwise adhesively attached. Metal or metal alloy contact pads (26 and 27) and interconnecting straps (28-36), suitably dimensioned and configured, are then adhesively formed on the flexible bare backed polyester sheet. One preferred process is to etch foil patterns by known processes after the metal or metal alloy has been laminated to the polyester film. Prior to forming the metal or metal alloy pads and straps, the flexible polyester sheet (25) is provided with apertures at locations coextensive with the pads and straps to provide for welding the metal or metal alloy material to the battery terminals.

The robotic process includes forming rollers (2), as shown in FIG. 1, which fold the configuration of FIG. 3 along the lines (37 and 38) into a U-shape, which shape is retained by the metal or metal alloy. A plurality of cells can now be placed between the legs of the U-shape as by battery cell feeder (3), and bonded by welding stations (4 and 5). The configuration shown in FIG. 3 is suitable for forming a ten cell battery pack. As contemplated by the present invention, the flexible polyester sheet (25) is a continuous sheet with multiple configurations of pads and straps laminated to the sheet to permit continuous processing.

Although a preferred embodiment of the present invention has been disclosed, numerous modifications are possible within the scope of the invention. For example, the forming rollers could be replaced by other forming structure. The flexible bare backed welding board and battery cells can be moved continuously along the processing line, and welded by flying spot welders or indexed along the processing line welded by spot welders which need only be moved to accommodate stacked cells. While fluid cylinders are disclosed to activate the welding electrodes, other structure is possible such as magnetic actuators. The spot welding power supplies can be of any suitable type. The flexible welding board shown in FIG. 3 shows only pads and straps for interconnecting battery cells. It is contemplated that other electrical or electromechanical circuit elements, for example switches, resistors, capacitors, diodes, thermistors, thermal switches and contacts, can be connected to the metal or metal alloy and even adhesively secured to the polyester film as may be required.

The term "flexible welding board" as used herein includes flexible welding substrates in general, irrespective of rigidity, thickness, shape or other features commonly associated with the word "board".

## Claims

1. A process for spot-welding a flexible welding board to at least one battery cell, characterised in that it comprises:
(a) using as the flexible welding board a flexible bare backed welding board;
(b) forming an electrical circuit pattern on the welding board;
(c) orienting a battery cell with respect to said electrical circuit pattern; and
(d) spot-welding said electrical circuit pattern to said battery cell.

2. A process of forming a battery pack comprising the steps of
(a) forming at least one circuit pattern on a continuous substrate;
(b) forming the substrate into a U-shaped configuration;
(c) depositing at least one battery cell within the legs of the U;
(d) welding one of said circuit patterns to terminals of said at least one cell; and
(e) separating the welded battery pack from said continuous substrate.

3. A process according to Claim 1 or 2, wherein the flexible welding board has formed therein apertures at pre-determined locations;
the electrical circuit pattern is formed on a first face of the flexible welding board;
the battery cell is orientated so that it is disposed adjacent a second face of the flexible welding board; and
said welding is effected at said pre-determined locations.

4. A process according to Claim 3, wherein the electrical circuit pattern comprises a strip or other sheet of a metal and the welding is effected so that the flexible welding board is secured between the battery cell and the metal sheet.

5. Apparatus for producing a battery pack, characterised in that the apparatus comprises:
(a) means for supplying flexible bare backed welding boards;
(b) means for forming said flexible bare backed welding boards into a U-shaped configuration;
(c) means for feeding at least one battery cell between the legs of one of the U-shaped flexible bare backed welding boards; and
(d) spot welding means for bonding said flexible bare backed welding board to the terminals of the said at least one battery cell.

6. Apparatus according to Claim 5, wherein said spot welding means is a resistance spot welder having at least two electrodes.

7. Apparatus according to Claim 6, wherein said spot welding means includes three electrodes in a triangular configuration.

8. Apparatus according to Claim 7, wherein said electrodes are supplied from means including two power sources having two like polarity terminals interconnected.

9. Apparatus according to Claim 8, including means connecting the interconnected terminals to one of the electrodes, and means connecting the other two electrodes to the two remaining terminals of said power sources.
